Europäisches Patentamt

European Patent Office

Office européen des brevets

(11) Veröffentlichungsnummer: **0 273 226 B1**

# (12) EUROPÄISCHE PATENTSCHRIFT

(45) Veröffentlichungstag der Patentschrift: **15.01.92**

(21) Anmeldenummer: **87117836.4**

(22) Anmeldetag: **02.12.87**

(51) Int. Cl.⁵: **H01L 21/00**

(54) **Transportbehälter mit austauschbarem, zweiteiligem Innenbehälter.**

(30) Priorität: **22.12.86 DE 3644034**

(43) Veröffentlichungstag der Anmeldung:
**06.07.88 Patentblatt 88/27**

(45) Bekanntmachung des Hinweises auf die
Patenterteilung:
**15.01.92 Patentblatt 92/03**

(84) Benannte Vertragsstaaten:
**DE FR GB IT**

(56) Entgegenhaltungen:
**EP-A- 0 151 336**
**WO-A-86/00870**
**WO-A-87/04043**
**US-A- 4 582 219**

(73) Patentinhaber: **SIEMENS AKTIENGESELL-
SCHAFT**
**Wittelsbacherplatz 2**
**W-8000 München 2(DE)**

(72) Erfinder: **Grohrock, Peter, Dipl.-Ing. FH**
**Leonhardstrasse 24**
**W-8011 Höhenkirchen(DE)**

**Beschreibung**

Die Erfindung betrifft einen Transportbehälter mit austauschbarem, zweiteiligem Innenbehälter zum Transport und zur Lagerung von Halbleiterscheiben in einer Halbleiterscheibenkassette.

Der Zweck der Verwendung von Transportbehältern für Halbleiterscheiben liegt hauptsächlich darin, die Halbleiterscheiben während eines Transports vor einer Verschmutzung durch die Umgebungsluft, die nicht den höchsten Reinheitsanforderungen entspricht, zu schützen. Aus diesem Grunde ist eine der wichtigsten Eigenschaften eines solchen Transportbehälters seine Partikeldichtheit.

Es gibt mehrere Möglichkeiten der Konzeption solcher Transportbehälter, beispielsweise gilt als eine besonders einfache Konstruktion, der Transportbehälter, der lediglich aus einer Außenhaube, einer äußeren Bodenplatte sowie eines Halbleiterscheibenhalters besteht. Eine andere aufwendigere Konstruktion liegt bei einem Transportbehälter mit austauschbarem Innenbehälter vor, an dessen Innenbehälter ein Halbleiterscheibenhalter befestigt ist. Alle gemeinsam sollten die Transportbehälter gleiche Größe und gleiche äußere Abmessungen haben, um untereinander austauschbar zu sein. Sie sollten gewisse standardisierte Ausmaße aufweisen.

Solche Standardisierungen für Transportbehälter sind beispielsweise in der Veröffentlichung des Dokuments Nr. 1332 von Semiconductor Equipment and Materials Institute, Inc. vom 10.1.1986 angegeben. Die empfohlenen Standardisierungen sind unter dem Begriff "Standard Mechanical Interface For Wafer Cassette Transfer" Standard kurz SMIF-Standard zusammengefaßt. In dieser Veröffentlichung sind alle wichtigsten Abmessungen eines Transportbehälters, sowie seine wesentlichen äußeren Bestandteile aufgeführt. Außerdem werden in dieser Veröffentlichung auch Empfehlungen über die Anforderung gegeben, die die Bestandteile des Transportbehälters erfüllen sollen.

In der Veröffentlichung SMIF-Pod "The Nucleus Of The Asyst-SMIF System" der Firma Asyst Technologies, Inc. wird ein Transportbehälter mit austauschbarem Innenbehälter vorgestellt. Dieser Transportbehälter ist nach den oben angeführten SMIF-Spezifikationen hergestellt und zur Aufnahme von Halbleiterscheiben geeignet. Eine zugehörige Querschnittszeichnung zeigt die Einzelheiten wie Innenhaube, Halbleiterscheibenhalter, Außenhaube und Bodenplatte dieses Transportbehälters beim Beladen mit einer Halbleiterscheibenkassette.

Es ist selbstverständlich bekannt, Transportbehälter für die Lagerung und für den Transport von Halbleiterscheiben einzusetzen. So werden solche Transportbehälter auch von verschiedenen Firmen, wie beispielsweise Asyst oder Empak hergestellt und vertrieben. Bei den bisherigen Transportbehältern handelt es sich jedoch entweder um Einfachkonstruktionen, bei denen keine Innenbehälter vorgesehen sind, oder um Transportbehälter mit nicht partikeldichten Innenbehältern. Die Anforderung bezüglich der Partikeldichtheit dieser Transportbehälter sind gering, so daß sie nur in Reinräumen mit gefilterter Umgebungsluft eingesetzt werden können. Ein anderer Nachteil bei Einfachkonstruktionen des Transportbehälters besteht darin, daß der Transportbehälter nach einer bestimmten Anzahl von Prozeßschritten im Halbleiterherstellungsverfahren getauscht und gereinigt werden muß. Bei Transportbehältern mit Innenbehälter wird in diesem Falle der verschmutzte Innenbehälter gegen einen neuen ausgetauscht.

Der Erfindung liegt die Aufgabe zugrunde, einen nach äußeren Abmessungen standardisierten, verschließbaren und staubdichten Transportbehälter herzustellen, dessen Halbleiterscheibenhalter unter Vermeidung von Reibung beweglich in der Innenhaube angeordnet ist.

Diese Aufgabe wird erfindungsgemäß durch die in Anspruch 1 angegebenen Merkmale gelöst.

Weitere Ausgestaltungen des Transportbehälters und des im Transportbehälter untergebrachten Halbleiterscheibenschalters ergeben sich aus den Unteransprüchen.

Die mit der Erfindung erzielten Vorteile bestehen insbesondere darin, daß der Transportbehälter mit den Halbleiterscheiben in Räumen geringer Reinraumklassen und auch in der Umgebungsluft eingesetzt werden kann. Durch die neuartige Konstruktion des Halbleiterscheibenhalters im Transportbehälter werden beim Beund Entladen des Behälters mit Halbleiterscheiben keine zusätzlichen Partikel freigesetzt. Bei schwankenden Druckverhältnissen sorgt ein Filter in der inneren Bodenplatte für eine partikelfreie Luftströmung.

Ein Ausführungsbeispiel der Erfindung ist in den Zeichnungen dargestellt und wird im folgenden näher beschrieben. Es zeigt

Figur 1
eine Übersichtszeichnung aller Einzelteile des Transportbehälters,

Figur 2
eine Querschnittszeichnung des Transportbehälters, mit einem in der inneren Bodenplatte eingelassenen Filterelement,

Figur 3, Figur 4
das Dichtungselement, zum luftdichten Abschluß des Transportbehälters und

Figur 5
den Halbleiterscheibenhalter.

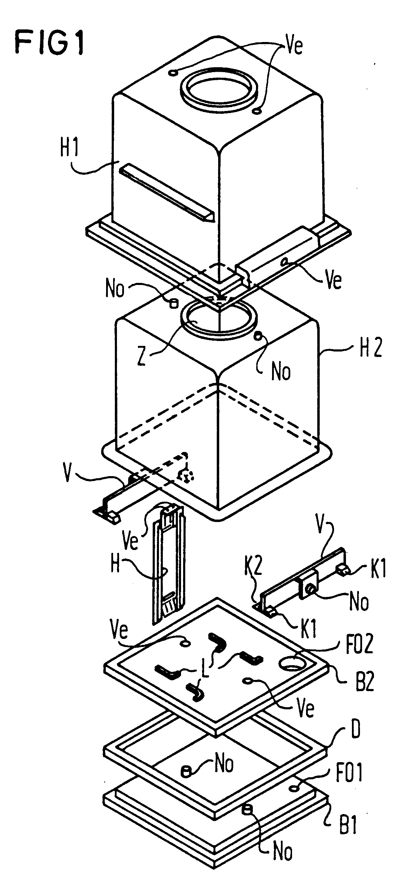

Der in Figur 1 dargestellte Transportbehälter enthält eine äußere Bodenplatte B1, ein Dichtungselement D, eine innere Bodenplatte B2, zwei Verschlußhebel V, einen Halbleiterscheibenhalter H, eine Innenhaube H2 sowie eine Außenhaube H1. In der äußeren Bodenplatte B1 sind zwei unterschiedlich dicke nach innen gerichtete Noppen No angeordnet, die zur Arretierung der inneren Bodenplatte B2 dienen. Das Dichtungselement D besteht aus einem geschäumten Silikonkautschukring mit einer darüber angeordneten Polyethylenfolie und wird in den u-förmigen Rand der inneren Bodenplatte B2 eingelegt. Die innere Bodenplatte B2 enthält zwei unterschiedlich große Vertiefungen Ve, zur Befestigung der inneren Bodenplatte B2 an die äußere B1. Die vier I-förmigen Erhöhungen L auf der inneren Bodenplatte B2 dienen zur Ablage einer Halbleiterscheibenkassette. Durch die Öffnungen F01 und F02 erfolgt die partikelfreie Luftströmung bei schwankenden Druckverhältnissen über ein in der inneren Bodenplatte B2 befestigtes Filterelement. Zwei Verschlußhebel V, zum kraftschlüssigen Schließen der Außenhaube A1 mit der äußeren Bodenplatte B1 sind je über eine Noppenvertiefung (No, Ve) Verbindung an der Außenhaube A1 befestigt. Sie weisen auf jeder Längsseite überstehende Kanten K1 und K2 auf, von denen die Kanten K1 Bohrungen enthalten, durch die Stifte einer Be- und Entlademaschine geführt werden, um den Transportbehälter automatisch öffnen und schließen zu können. Die Innenhaube H2 und die Außenhaube H1 ebenso wie der Halbleiterscheibenhalter H und die Innenhaube H2 sind über Noppen-Vertiefung (No, Ve) Verbindungen miteinander verbunden. Ein Zentrierungsring Z auf der Innenhaube H2 erleichtert ein schnelles Befestigen der Innenhaube H2 an die Außenhaube H1. Für die Abmessungen der Einzelteile des Transportbehälters wurden die Angaben des SMIF-Standards von Semiconductor Equipment and Materials Institute, Inc., ausgewählt.

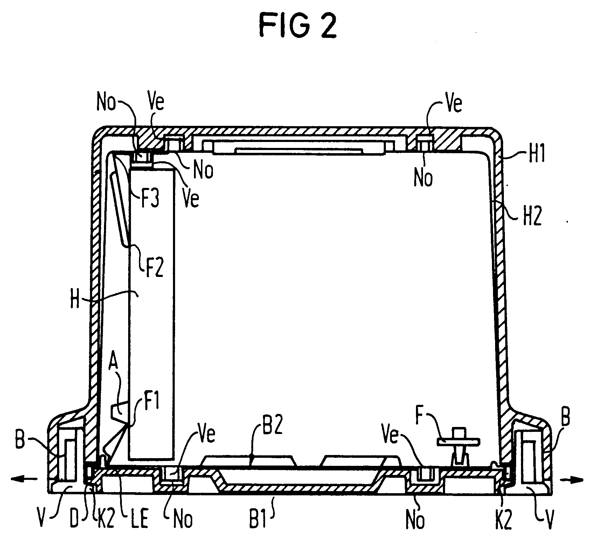

Die als Querschnittszeichnung des Transportbehälters angegebene Figur 2 gibt nochmals alle Einzelteile des Behälters wieder. Zu diesen zählen die äußere Bodenplatte B1, das Dichtungselement D, die innere Bodenplatte B2, zwei Verschlußhebel V, ein Halbleiterscheibenhalter H, eine Innenhaube H2, sowie eine Außenhaube H1. Die Befestigung des Halbleiterscheibenhalters H zur Innenhaube H2, die Innenhaube H2 zur Außenhaube H1 und ebenfalls die innere Bodenplatte B2 zur äußeren Bodenplatte B1 erfolgt über Noppen-Vertiefung (No, Ve) Verbindungen, die den Vorteil einer leicht lösbaren Verbindung besitzen. Deutlich zu erkennen sind die überstehenden Kantenteile K2 der Verschlußhebel V, die die äußere Bodenplatte B1 über das Dichtungselement D mit der Außenhaube H1 verschließen. Ein Öffnen des Transportbehälters geschieht durch die Bewegung der Verschlußhebel V in die angegebene Pfeilrichtung. Über die Befestigungsbügel B der Verschlußhebel V, die über je eine Noppen-Vertiefung Verbindung an die Außenhaube befestigt sind, wird dann im geöffneten Zustand eine Federkraft in die ursprüngliche Verschlußposition ausgeübt. Da der Transportbehälter unterschiedlichen Druckverhältnissen ausgesetzt ist, sorgt ein Filterelement F, an der inneren Bodenplatte B2 für eine partikelfreie Luftströmung. Statt eines zusätzlichen Filterelements ist es ebenfalls möglich, eine Filtermembran in die innere Bodenplatte B2 einzuarbeiten. Der Halbleiterscheibenhalter H ist über die Filmgelenke F1, F2 und F3 beweglich in der Innenhaube H2 gelagert und weist einen Abstandshalter A auf, durch den ein Minimalabstand zwischen Halbleiterscheibenhalter H und Innenhaube H2 eingehalten wird. Die Leiste LE der inneren Bodenplatte 2 dient zur Abstützung des unteren Teils des Halbleiterscheibenhalters H.

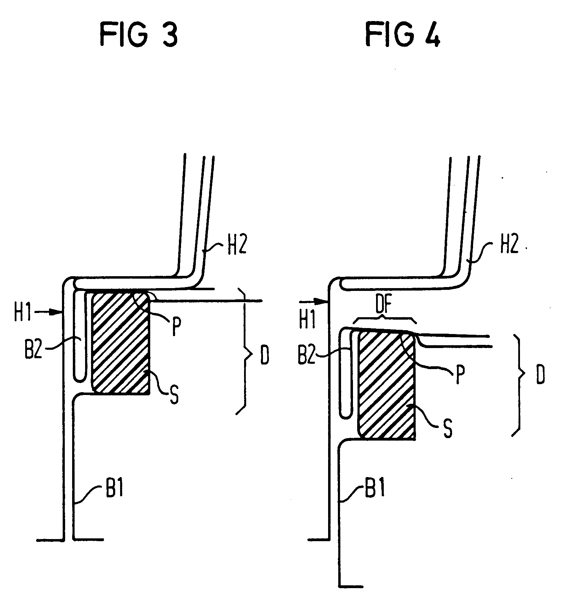

Figur 3 und Figur 4 zeigen das Dichtungselement D bestehend aus einem geschäumten Silikonkautschukring S und einer darüber angeordneten Polyethylenfolie P. Die Folienwandstärke an der Dichtfläche DF beträgt ungefähr 0,1 mm. Zur Erhöhung der Dichtigkeit überlappt die innere Bodenplatte B2 den Silikonkautschukring S. Figur 3 zeigt das Dichtungselement D im Zustand des geschlossenen Transportbehälters, in Figur 4 dagegen ist der Transportbehälter geöffnet. Dabei sind deutlich auf beiden Figuren die äußeren Umrisse der Innenhaube H2, der äußeren Bodenplatte B1 und der Außenhaube H1 erkennbar.

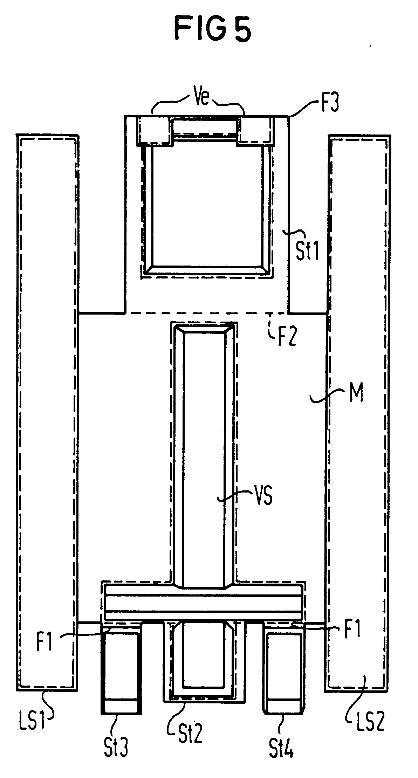

In Figur 5 ist der Halbleiterscheibenhalter für den Transportbehälter wiedergegeben. Er enthält zwei seitliche Längsstege LS1 und LS2 und einen verstärkten Mittelsteg M, durch die Verstärkung VS auf dem Mittelsteg M berühren die Halbleiterscheiben den Halbleiterscheibenhalter nur an dieser Verstärkung VS. Im unteren Teil des Mittelstegs M des Halbleiterscheibenhalters sind über zwei dünne Filmgelenke F1 zwei bewegliche schmale Aufstellstege St3 und St4 angebracht, die in der Mitte durch einen feststehenden Steg St2 ergänzt werden. Der obere Teil enthält zwei Vertiefungen Ve über die der Halbleiterscheibenhalter an die Innenhaube befestigt werden kann. Diese Vertiefungen Ve sind mit einem in der Zeichnung senkrecht angeordneten weiteren Steg über ein Filmgelenk F3 mit dem Steg St1 und dieser über das Filmgelenk F2 mit dem Mittelsteg M verbunden. Die Filmgelenke F2 und F3 sind dabei stärker und unflexibler ausgebildet als die Filmgelenke F1.

**Patentansprüche**

1. Transportbehälter mit austauschbarem zweiteiligen Innenbehälter zum Transport und Zur Lagerung von Halbleiterscheiben in einer Halbleiterscheibenkassette, bestehend aus:

   - einer Außenhaube (H1) und einer äußeren Bodenplatte (B1),
   - einer Innenhaube (H2) und einer inneren Bodenplatte (B2), die den geschlossenen zweiteiligen Innenbehälter bilden,

- zwei Verschlußhebel (V), zum kraftschlüssigen Schließen der Rußenhaube und der äußeren Bodenplatte,

- einem Dichtungselement (D), zum luftdichten Abschluß des Transportbehälters,

- einem durch Filmgelenke beweglichen, an der Innenhaube befestigten, austauschbaren Halbleiterscheibenhalter (H).

2. Transportbehälter nach Anspruch 1, **dadurch gekennzeichnet,** daß in der inneren Bodenplatte (B2) ein Filter (F) angeordnet ist, der für eine partikelfreie Luftströmung bei schwankenden Druckverhältnissen sorgt.

3. Transportbehälter nach Anspruch 1 oder 2, **dadurch gekennzeichnet,** daß in der inneren Bodenplatte (B2) zwei unterschiedlich große sternförmige Vertiefungen (Ve) eingelassen sind, zur Arretierung der inneren Bodenplatte (B2) mit der äußeren Bodenplatte (B1).

4. Transportbehälter nach einem der Ansprüche 1 bis 3, **dadurch gekennzeichnet,** daß auf der inneren Bodenplatte (B2) vier 1-förmige Erhöhungen (L) zur Ablage einer Halbleiterscheibenkassette angeordnet sind.

5. Transportbehälter nach einem der Ansprüche 1 bis 4, **dadurch gekennzeichnet,** daß ein umlaufender u-förmiger Rand zur Aufnahme des Dichtungselements (D) an der inneren Bodenplatte (B2) angeordnet ist.

6. Transportbehälter nach einem der Ansprüche 1 bis 5, **dadurch gekennzeichnet,** daß auf der Innenhaube (H2) zwei nach innen gerichtete sternförmige Noppen (No) angeordnet sind, an die der Halbleiterscheibenhalter (H) befestigt ist.

7. Transportbehälter nach einem der Ansprüche 1 bis 6, **dadurch gekennzeichnet,** daß auf der Innenhaube (H2) nach außen gerichtete sternförmige Noppen (No) angeordnet sind, an die die Außenhaube befestigt ist.

8. Transportbehälter nach einem der Ansprüche 1 bis 7, **dadurch gekennzeichnet,** daß im Zentrum der Innenhaube ein nach außen gerichteter Zentrierungsring (Z) angeordnet ist.

9. Transportbehälter nach einem der Ansprüche 1 bis 8, **dadurch gekennzeichnet,** daß die Außenhaube (H1) Vertiefungen (Ve) aufweist, zum Befestigen der Verschlußhebel (V) und der Innenhaube (H2).

10. Transportbehälter nach einem der Ansprüche 1 bis 9, **dadurch gekennzeichnet,** daß das Dichtungselement (D) ein geschäumter Silikonkautschukring (S) und eine darüber angeordnete Polyethylenfolie (P) ist.

11. Transportbehälter nach Anspruch 10, **dadurch gekennzeichnet,** daß die Skleroskophärte des Silkonkautschuksrings (S) 5$^{\circ}$ Shore ist und daß die Polyethylenfolie (P) ca. 0,1 mm dick ist.

12. Transportbehälter nach einem der Ansprüche 1 bis 11, **dadurch gekennzeichnet,** daß der austauschbare Halbleiterscheibenhalter (H) aus zwei seitlichen Längsstegen (LS1, LS2) und einem verstärkten Mittelsteg (M) gebildet ist, daß der Mittelsteg (M) nach oben mit einem schmalen dritten Steg (St1) über ein erstes Filmgerät (F2) verbunden ist, daß der dritte schmale Steg seinerseits über ein zweites Filmgelenk (F3) mit einem senkrecht angeordneten vierten Steg, auf dem zwei Vertiefungen (Ve) zur Befestigung an die Innenhaube (H2) aufgebracht sind, verbunden ist, daß nach unten der Mittelsteg (M) über je ein Filmgelenk (F1) mit einem fünften und sechsten Steg (St3, St4) und in der Mitte des Mittelsteges (M) mit einem siebten Steg (St2) verbunden ist, daß am Halbleiterscheibenhalter (H) im unteren Bereich ein Abstandshalter (A) angeordnet ist, der für einen Abstand zwischen der Innenhaube (2) und dem Halbleiterscheibenhalter (H) sorgt.

**Claims**

1. Transporting container with an interchangeable two-part inner container for transporting and for storing semiconductor wafers in a semiconductor wafer cassette, consisting of:

- an outer cover (H1) and an outer baseplate (B1),

- an inner cover (H2) and an inner baseplate (B2) which form the enclosed, two-part inner container,

- two closing levers (V) for non-positively closing the outer hood and the outer baseplate,

- a sealing element (D) for the air-tight sealing of the transporting container,

- an interchangeable semiconductor wafer holder (H) which can be moved by film joints and is attached to the inner cover.

2. Transporting container according to Claim 1, characterised in that arranged in the inner baseplate (B2) is a filter (F) which ensures a particle-free air stream in the case of fluctuating pressure conditions.

3. Transporting container according to Claim 1 or 2, characterised in that formed in the inner baseplate (B2) are two star-shaped depressions (Ve) of different sizes for securing the inner baseplate (B2) to the outer baseplate (B1).

4. Transporting container according to one of Claims 1 to 3, characterised in that four l-shaped elevations (L) for receiving a semiconductor wafer cassette are arranged on the inner baseplate (B2).

5. Transporting container according to one of Claims 1 to 4, characterised in that a circumferential u-shaped edge for receiving the sealing element (D) is arranged on the inner baseplate (B2).

6. Transporting container according to one of Claims 1 to 5, characterised in that arranged on the inner cover (H2) are two inwardly directed star-shaped knobs (No) to which the semiconductor wafer holder (H) is attached.

7. Transporting container according to one of Claims 1 to 6, characterised in that arranged on the inner cover (H2) are outwardly directed star-shaped knobs (No) to which the outer cover is attached.

8. Transporting container according to one of Claims 1 to 7, characterised in that an outwardly directed centring ring (Z) is arranged in the centre of the inner cover.

9. Transporting container according to one of Claims 1 to 8, characterised in that the outer cover (H1) has depressions (Ve) for attaching the closing levers (V) and the inner cover (H2).

10. Transporting container according to one of Claims 1 to 9, characterised in that the sealing element (D) is a foamed silicone rubber ring (S) and a polyethylene film (P) arranged thereon.

11. Transporting container according to Claim 10, characterised in that the material hardness of the silicone rubber ring (S) is 5° Shore and in that the polyethylene film (P) is approximately 0.1 mm thick.

12. Transporting container according to one of Claims 1 to 11, characterised in that the interchangeable semiconductor wafer holder (H) is formed from two lateral longitudinal webs (LS1, LS2) and a reinforced centre web (M), in that the centre web (M) is connected upwards to a narrow third web (St1) via a first film device (F2), in that the third narrow web itself is connected via a second film joint (F3) to a perpendicularly arranged fourth web on which two depressions (Ve) for attachment to the inner cover (H2) are mounted, in that the centre web (M) is connected downwards via in each case one film joint (F1) to a fifth and sixth web (St3, St4) and in the centre of the centre web (M) to a seventh web (St2), in that a spacing element (A) is arranged on the semiconductor wafer holder (H) in the lower region, which element ensures spacing between the inner cover (2) and the semiconductor wafer holder (H).

**Revendications**

1. Récipient de transport comportant un récipient intérieur interchangeable en deux éléments pour le transport et le stockage de plaquettes à semiconducteurs dans une cassette pour plaquettes à semiconducteurs, constitué par :
   - un capot extérieur (H1) et une plaque extérieure de base (B1),
   - un capot intérieur (H2) et une plaque intérieure de base (B2), qui forment le récipient intérieur fermé, constitué de deux éléments,
   - deux leviers de fermeture (V) servant à fermer selon une liaison de force le capot extérieur de la plaque extérieure de base,
   - un élément d'étanchéité (D) pour fermer, d'une manière étanche à l'air, le récipient de transport,
   - un support interchangeable (H) de plaquettes à semiconducteurs, qui est mobile au moyen d'articulations en forme de pellicules et est fixé sur le capot intérieur.

2. Récipient de transport suivant la revendication 1, caractérisé par le fait que dans la plaque intérieure de base (B2) est disposé un filtre (F) assurant un écoulement d'air sans particules, dans des conditions de pression variables.

3. Récipient de transport suivant la revendication 1 ou 2, caractérisé par le fait que dans la plaque intérieure de base (B2) sont ménagés deux renfoncements (Ve) en forme d'étoile, possédant des tailles différentes et servant à bloquer la plaque intérieure de base (B2) avec la plaque extérieure de base (B1).

4. Récipient de transport suivant l'une des revendications 1 à 3, caractérisé par le fait que quatre bossages en forme de 1 (L) sont prévus sur la plaque intérieure de base (B2) pour supporter une cassette pour microplaquettes à semiconducteurs.

5. Récipient de transport suivant l'une des revendications 1 à 4, caractérisé par le fait qu'un bord périphérique en forme de u est prévu, pour y loger l'élément d'étanchéité (D), sur la plaque intérieure de base (B2).

6. Récipient de transport suivant l'une des revendications 1 à 5, caractérisé par le fait que sur le capot intérieur (H2) sont disposés deux boutons en forme d'étoile (No), qui sont dirigés vers l'intérieur et sur lesquels est fixé le support (H) de microplaquettes à semiconducteurs.

7. Récipient de transport suivant l'une des revendications 1 à 6, caractérisé par le fait que sur le capot intérieur (H2) sont disposés des boutons en forme d'étoile (No) dirigés vers l'extérieur et auxquels est fixé le capot extérieur.

8. Récipient de transport suivant l'une des revendications 1 à 7, caractérisé par le fait qu'au centre du capot intérieur est disposé un anneau de centrage (Z) dirigé vers l'extérieur.

9. Récipient de transport suivant l'une des revendications 1 à 8, caractérisé par le fait que le capot extérieur (H1) comporte des renforcements (Ve) servant à fixer les leviers de fermeture (V) et le capot intérieur (H2).

10. Récipient de transport suivant l'une des revendications 1 à 9, caractérisé par le fait que l'élément d'étanchéité (D) est une bague en caoutchouc silicone à l'état de mousse (S), sur lequel est disposée une feuille de polyéthylène (P).

11. Récipient de transport suivant la revendication 10, caractérisé par le fait que la dureté, mesurée au scléroscope, de la bague en caoutchouc silicone (S) possède la valeur 5° Shore et que la feuille de polyéthylène (P) possède une épaisseur d'environ 0,1 mm.

12. Récipient de transport suivant l'une des revendications 1 à 11, caractérisé par le fait que le support interchangeable (H) des microplaquettes à semiconducteurs est formé de deux branches longitudinales latérales (LS1,LS2) et d'une branche médiane renforcée (M), que la branche médiane (M) est raccordée vers le haut à une troisième barrette étroite (Sr), par l'intermédiaire d'une première articulation en forme de pellicule (F2), que la troisième barrette est raccordée pour sa part par l'intermédiaire d'une seconde articulation en forme de pellicule (F3) à une quatrième barrette perpendiculaire, dans laquelle sont ménagés deux renfoncements (Ve) pour la fixation sur le capot intérieur (F2), que vers le bas, la barrette médiane (M) est raccordée par l'intermédiaire d'une articulation en forme de pellicule (F1) à des cinquième et sixième barrettes (St3,St4) et, au centre de la barrette médiane (M), à une septième barrette (St2), que sur le support (H) de microplaquettes à semiconducteurs est disposée, dans la partie inférieure, une entretoise (A) qui garantit le maintien d'une distance entre le capot intérieur (2) et le support (H) de la microplaquette à semiconducteurs.

# FIG 1

# FIG 2

# FIG 3     FIG 4

# FIG 5